# EUROPEAN PATENT APPLICATION

(11) **EP 2 489 683 A1**
(43) Date of publication of application: **22.08.2012**
(21) Application number: 10823349.5
(22) Date of filing: 08.10.2010
(51) Int. Cl.: C08F 2/00, B32B 15/08, C09C 1/62, C09C 3/10, C23C 22/08, H05K 3/28, H05K 9/00

(54) **PROCESS FOR PRODUCTION OF CORE-SHELL PARTICLES, CORE-SHELL PARTICLES, AND PASTE COMPOSITION AND SHEET COMPOSITION WHICH CONTAIN SAME**

(30) Priority: 15.10.2009 JP 2009237995
(71) Applicant: Toray Industries, Inc., Tokyo 103-8666 (JP)
(72) Inventor: SHINBA, Yoichi, Otsu-shi Shiga 520-8558 (JP); NIIZEKI Shoichi, Otsu-shi Shiga 520-8558 (JP); NONAKA, Toshihisa, Otsu-shi Shiga 520-8558 (JP)
(74) Representative: Hager, Thomas Johannes
(86) International application number: PCT/JP2010/067748
(87) International publication number: WO 2011/046081

(57) **Abstract**

Disclosed is a process with comprises bringing an acidic organic substance or phosphoric acid into contact with a metal to form, on the surface of the metal, a layer that contains either an organic acid salt formed from both the acidic organic substance and the metal or a phosphoric acid salt formed from both the phosphoric acid and the metal. In the process, the layer can be selectively formed only on the surface of the metal. When the process is applied to the production of core-shell particles, neither agglomeration of the particles nor viscosity increase of the fluid occurs, while when the process is applied to the production of a covered metal-wiring circuit board, the layer can be selectively formed only in the metal area to be covered.

## Description

### BACKGROUND OF THE INVENTION

### (1) Field of the Invention

The present invention relates to a technology of covering the surface of a metal such as a metal particle or a metal-wiring with a layer. More particularly, the present invention relates to a technology of bringing an acid organic material or phosphoric acid into contact with a metal to form, on the surface of the metal, a layer containing an organic acid salt or phosphate.

The present invention also relates to a metal particle covered with a layer (shell), an insulating material having a high thermal conductivity or a high magnetic permeability, in which the metal particles are dispersed, and a covering material for a metal-wiring or a metal joint area on a circuit board.

### (2) Description of the Related Art

As products with a higher density, a higher frequency or higher performance have been increasing in devices such as ICs, lasers and LEDs in electronic equipment such as mobile phones, personal computers and the like, the quantity of local evolution of heat from these devices is increasing, and provisions for heat release become important. Further, electromagnetic interference between devices is also a problem. For this situation, a technology of improving a thermal conductivity or a magnetic permeability of an insulating material by dispersing metal particles with a high thermal conductivity or a high magnetic permeability in the insulating material is known. However, sometimes the metal particles dispersed in the insulating material are re-agglomerated into a string to form a path of the metal particles in the insulating material, resulting in the deterioration of insulation properties.

For this situation, core-shell particles having a structure in which the surface of a metal particle is covered with a resin layer are known (e.g., Japanese Unexamined Patent Publication No.8-227611 and Japanese Unexamined Patent Publication (translation of PCT application) No.2002-518182). The core-shell particles have good dispersibility in a resin since each of the metal particles (cores) is covered with a resin layer (shell). Further, even though the core-shell particles are agglomerated during a process, the path of the metal particles is not formed and the above-mentioned problem can be avoided.

Examples of a process for forming a resin layer on the surface of a metal particle include a process in which metal particles are dispersed in a solvent such as water or an organic solvent, a monomer or a polymerizable polymer is added as a resin for forming a shell, and further a thermal polymerization initiator for polymerizing a resin for forming a shell is added, and these resins for forming a shell are polymerized by a heating treatment to form a shell of a resin layer on the surface of the particle.

On the other hand, as a process for covering a metal substrate with a resin layer, a process of applying a mixed liquid of a monomer or a polymerizable polymer onto a substrate and polymerizing the applied monomer or polymer is known (e.g., Japanese Unexamined Patent Publication (translation of PCT application) No.2001-523769 and Japanese Unexamined Patent Publication No.2005-296789).

### SUMMARY OF THE INVENTION

However, in a conventional process for production of core-shell particles, there were a problem that since the resin for forming a shell is polymerized not only on the surface of the metal particle, but also at other locations, starting from a polymer of the resin formed at locations other than the surface of the metal particle, particles are agglomerated with one another, and a problem that viscosity of a reaction liquid for forming a shell increases to interfere with the progress of a reaction. Further, an area where the shell is not formed may exist in a part of the surface of the metal particle, thereby leading to insufficient insulation properties of an insulating material formed by dispersing the resulting core-shell particles in a matrix resin.

On the other hand, in a conventional process for covering a metal substrate, a resin layer is also formed at a site other than a metal area, and thereby the realization of a smaller and lighter substrate may be inhibited or cracks of the substrate may occur.

It is an object of the present invention to solve such problems and provide a process in which a layer is selectively formed on the surface of a metal.

That is, the present invention pertains to a process for production of core-shell particles comprising the step of mixing an acid organic material or phosphoric acid with metal particles to form, on the surface of the metal particle, a layer containing an organic acid salt formed from both the acid organic material and the metal or phosphate formed from both the phosphoric acid and the metal.

Further, another aspect of present invention pertains to a process comprising the step of bringing an acid organic material or phosphoric acid into contact with a metal to form, on the surface of the metal, a layer containing an organic acid salt formed from both the acid organic material and the metal or phosphate formed from both the phosphoric acid and the metal.

In accordance with present invention, the layer is selectively formed on the surface of the metal. When by applying this, core-shell particles, each of which comprises a core of a metal particle and a layer (shell) at the surface of the metal particle, are produced, the core-shell particles can be obtained without causing agglomeration of the particles or viscosity increase of a reaction liquid for forming a shell.

On the other hand, when the technology of present invention is applied to the formation of a layer covering a metal-wiring or a metal joint area on a circuit board, the layer can be selectively formed only in the metal area to be covered.

### BRIEF DESCRIPTION OF THE DRAWINGS

Fig. 1 is a view showing an example of a SEM image of the surface of a core-shell particle obtained by a process of the present invention;
Fig. 2 is a view showing an example of a SEM image of the surface of a core-shell particle obtained by a process of the present invention;
Fig. 3 is a view showing an example of a SEM image of the cross section of a core-shell particle obtained by a process of the present invention;
Fig. 4 is a SEM image of the surface of a core-shell particle obtained in Example 2;
Fig. 5 is a SEM image of the surface of a core-shell particle obtained in Example 3;
Fig. 6 is a SEM image of the surface of a core-shell particle obtained in Example 6;
Fig. 7 is a SEM image of the surface of a core-shell particle obtained in Example 10;
Fig. 8 is a SEM image of the surface of a core-shell particle obtained in Example 17;
Fig. 9 is a SEM image of the surface of a core-shell particle obtained in Example 31;
Fig. 10 is a front view of a joint face of a semiconductor device;
Fig. 11 is a front view of a joint face of a substrate; and
Fig. 12 is a sectional view of a joint area after joining a semiconductor device to a substrate.

### DETAILED DESCRIPTION OF THE PREFERRED EMBODIMENT

In accordance with the technology described in the present specification, a layer containing an organic acid salt formed from both an acid organic material and a metal or phosphate formed from both a phosphoric acid and a metal can be formed on the surface of the metal by bringing the acid organic material or phosphoric acid into contact with the surface of the metal. Applying this technology, core-shell particles can be produced by mixing an acid organic material or phosphoric acid with metal particles to form, on the surface of the metal particle, a layer containing an organic acid salt formed from both the acid organic material and the metal or phosphate formed from both the phosphoric acid and the metal.

The contact between the acid organic material or phosphoric acid and the metal is preferably performed in a state in which the acid organic material or phosphoric acid is dissolved in a solvent. Examples of the process of bringing an acid organic material or phosphoric acid into contact with a metal in such a state include a process of mixing a metal in a solution of an acid organic material or phosphoric acid, a process of mixing an acid organic material or phosphoric acid in a dispersion of a metal and a process of mixing an acid organic material or phosphoric acid and a metal in a solvent. Any solution may contain a resin, a silane coupling agent, a polymerization initiator and the like described later, other than the acid organic material, phosphoric acid and metal. A specific process of forming a layer on the surface of a metal will be described in detail later.

A mechanism, in which in the present technology, a layer is formed on the surface of the metal when the acid organic material or phosphoric acid is brought into contact with the metal, is thought as follows.

First, when the acid organic material or phosphoric acid is brought into contact with the surface of the metal, reaction occurs between these to produce an organic acid salt or phosphate on the surface of the metal. The organic acid salt or phosphate grows while having a specific morphology depending on the type of the acid organic materials or metals, a temperature of a reaction system and conditions of stirring a solution. In this manner, an organic acid salt formed from the acid organic material and the metal, or phosphate formed from the phosphoric acid and the metal forms a layer.

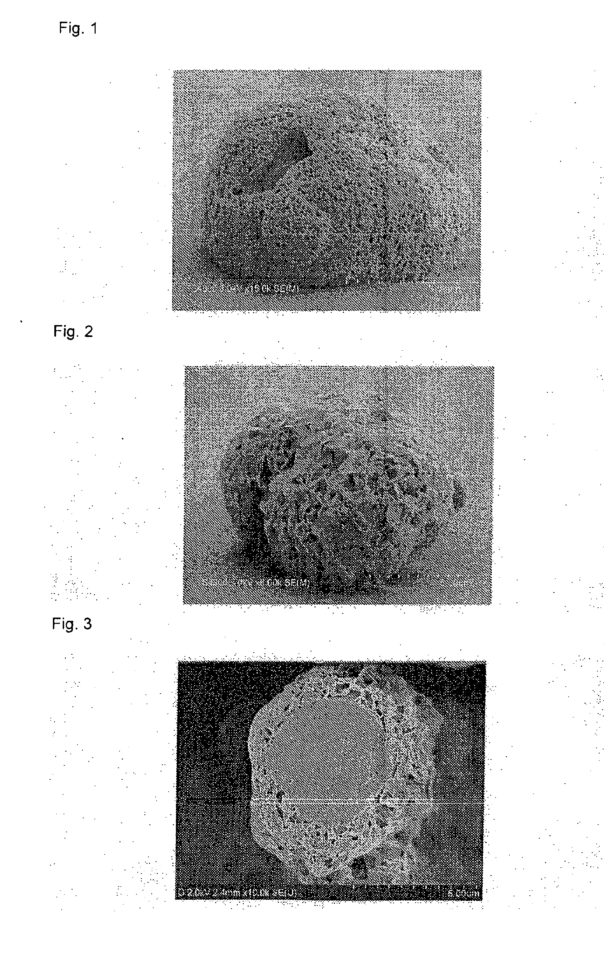

This mechanism is estimated from the following facts. First, elemental analysis of the surface of core-shell particles (Fig. 1), which are prepared by the process described in the present specification using copper particles as a metal particle and a carboxyl group-containing acrylate resin "HOA-MPL" (manufactured by KYOEISHA CHEMICAL Co., Ltd.) as an acid organic material, was performed by Auger electron spectroscopy, and consequently Cu, C and O were detected. Further, elemental analysis of the surface of core-shell particles (Fig. 2), which are prepared by the process described in the present specification using copper particles and phosphoric acid, was performed by energy dispersive X-ray spectroscopy (EDX), and consequently Cu, P and O were detected. From these facts, it could be verified that the shell contains a metal and a component of an organic material or a phosphorus based compound. Moreover, the surfaces of the above-mentioned two types of particles were analyzed by Fourier transform infrared spectroscopy (FT-IR), and consequently the existences of carboxylate and phosphate could be confirmed.

In the present technology, a metal, of which a layer is going to be formed on the surface, is not particularly limited, and examples of the metal include pure metals such as copper, silver, aluminum, iron, zinc, tin, nickel, chromium, titanium, lead and gold; and alloys such as solder, brass, bronze and stainless steel. Among these, to pure metals of any of copper, silver, aluminum, iron, zinc, tin and gold, or alloys containing at least one of these elements, the technology of present invention can be preferably applied. Further, also to intermetallic compounds containing at least one of these elements, the technology of present invention can be preferably applied. For example, when the insulating material with dispersed metal particles is produced by use of core-shell particles with a layer formed on the surface of the metal particle, use of silver or copper particles having a high thermal conductivity is preferred since thermal conductivity of a cured product of the insulating material becomes better. Further, use of iron particles having a high magnetic permeability is preferred since the inductance of a circuit can be increased when the cured product of the insulating material is used for a part of the circuit, or a large effect can be achieved when the cured product is used as an electromagnetic shielding material.

When the core-shell particle is produced, a number average particle size of the metal particles to be used is preferably 10 nm or more and 10 µM or less. When the number average particle size of the metal particles is 10 nm or more, since agglomeration between metal particles is inhibited, there is no coarse particle and core-shell particles of a uniform particle diameter can be stably produced. On the other hand, the number average particle size of the metal particles is 10 µm or less, the uniformity of the insulating material with dispersed metal particles, produced by using the core-shell particles and the cured product thereof is enhanced, and unevenness of physical properties such as a refractive index and dielectric constant becomes small. Further, when the insulating material is formed into a paste and applied onto a circuit board where there are bumps and dips such as a wiring, if the number average particle size of the metal particles is 10 µm or less, embeddability into fine bumps and dips is favorable. Further, if the number average particle size of the metal particles is 10 µm or less, cracks of the cured product are reduced and reliability of insulation properties is favorable. Examples of a method of measuring the number average particle size of the metal particles include a method in which particles are directly observed by using a SEM (scanning electron microscope) or a TEM (transmission electron microscope) and the number average particle size of the particle diameter is calculated. Specifically, diameters of any 100 particles are measured to determine the number average particle size. When the particle is noncircular, the smallest round shape of round shapes which embrace all of the particles, and the largest round shape of round shapes which embrace a part of the particles and do not embrace an area other than the particles are respectively determined, and an average of diameters of these two round shapes is taken as a diameter of the particles, and this diameter is taken as a particle diameter.

The acid organic material in the present technology refers to a mixture, a pH of which is 1.0 or more and 4.0 or less when an acid organic material and ultrapure water are mixed in a weight ratio of 1 : 99. A pH of a mixture composed of an acid organic material and ultrapure water in a weight ratio of 1 : 99 can be measured by a pH meter. Examples of the pH meter include "CyberScan pH310" manufactured by EUTECH INSTRUMENTS Pte Ltd. Even when the acid organic material is not completely dissolved in ultrapure water and a part thereof remains without being dissolved, a pH can be similarly measured as-is.

Examples of the acid organic material include methyl phosphate and ethyl phosphate which are phosphate-containing resins; "P-1M" and "P-2M" manufactured by KYOEISHA CHEMICAL Co. , Ltd., which are phosphate-containing acrylate resins; and "HOA-MS" and "HOA-MPL" manufactured by KYOEISHA CHEMICAL Co., Ltd., "KAYARAD ZAR-1395H" manufactured by Nippon Kayaku Co., Ltd., and "UE9000" manufactured by DIC Corp., which are respectively carboxyl group-containing resins.

Further, when the acid organic material has a polymerizable group such as an acrylate group, a vinyl group or an epoxy group, it is preferred since polymerizable groups in acid organic materials are coupled with each other in forming a layer to form a robust network, and therefore thermomechanical properties and insulation properties of the layer is favorable. As the acid organic material having these polymerizable groups, phosphate-containing acrylate resins or carboxyl group-containing acrylate resins are preferably used.

When the molecular weight of the acid organic material is 1000 or less, the acid organic material is easily dissolved in a solvent and has high reactivity, and therefore it is preferred since the layer can be easily formed on the surface of the metal.

Phosphoric acid is preferred since it has high reactivity with the metal particle and rapidly reacts with the metal particle at the surface of the metal even at a low temperature of 40 to 60°C to form a layer.

In the present technology, when a layer (shell) is formed on the surface of the metal particle to produce a core-shell particle, it is also possible that a part of the acid organic material in a mixture is reacted at the surface of the metal particle to form a shell and an unreacted acid organic material exists in the mixture. In this case, the unreacted acid organic material can also be used as a matrix resin without adding a matrix resin separately in producing the insulating material with dispersed metal particles containing the core-shell particles.

Plural types of acid organic materials can also be used in combination. The acid organic material and phosphoric acid can also be used in combination. For example, when phosphoric acid is used in combination with a carboxyl group-containing acrylate resin "HOA-MPL" to produce core-shell particles, the insulation property and the thermal conductivity of a cured product of an insulating material with dispersed metal particles produced by mixing the obtained core-shell particles in an acrylate resin, as a matrix resin, are favorable. This is considered to be due to the following that because the phosphate growing from the surface of the metal and the organic acid salt derived from "HOA-MPL" complementarily form a more compact network than the case of a single salt based on the difference in the respective hardness, flexibility and forms of growth. It is thought that thereby, in the insulating material with dispersed metal particles produced by use of this core-shell particle, the metal particle and the matrix resin form a void-less and compact structure, and various properties of the cured product of the insulating material are favorable.

In bringing the acid organic material or phosphoric acid into contact with the metal, a resin other than the acid organic material or phosphoric acid to react at the surface of the metal may be contained in the reaction system. When the core-shell particles produced in such a reaction system are mixed with a matrix resin to produce an insulating material with dispersed metal particles, the insulation property of a cured product of the insulating material is favorable, and the thermal conductivity of the cured product increases. In the present technology, the acid organic material or phosphoric acid reacts with a metal at the surface of the metal to form an organic acid salt or phosphate, but it is thought that even a resin, which is not directly involved in this reaction, is tangled with a network of the organic acid salt or the phosphate and incorporated in the network to constitute a part of the layer, and therefore a more compact layer structure is formed. Accordingly, it is thought that the above properties of the insulating material with dispersed metal particles, produced by using the core-shell particle, are favorable.

Examples of the resin include thermosetting or ultraviolet-curable resins having a polymerizable group such as polyamic acid, vinyl resin, norbornene resin, epoxy resin, acrylate resin, epoxy-acrylate resin, cyanate resin, bismaleimide-triazine resin, benzocyclobutene resin and siloxane resin. Also, examples of the resin include thermoplastic resins such as aramid resin, polystyrene, polyetherimide, polyphenylene ether and thermoplastic polyimide. When the resin is a resin having a polymerizable group, after the layer is formed, the resin can be further polymerized to make the layer robust. For example, when the surface of the metal on the circuit board is covered using the present technology, the layer existing at a site other than the metal area after formation of the layer is removed, and then a polymerizable group-containing resin in the layer formed at the metal area can be polymerized by a heating treatment or by light irradiation.

Examples of the solvent preferably used in the present technology include ultrapure water, dimethylsulfoxide, γ-butyrolactone, ethyl lactate, isopropyl alcohol, n-butyl acetate, methyl isobutyl ketone, 1-methoxy-2-propanol, 1-ethoxy-2-propanol, 4-methyl-2-pentanol, ethylene glycol mono-n-propyl ether, diacetone alcohol, propylene glycol monomethylether acetate and tetrahydrofurfuryl alcohol (abbreviated to THFA). When the core-shell particles with a layer formed on the surface of the metal particle are produced and mixed in another matrix resin as required to produce a insulating material with dispersed metal particles, if a solvent in which the matrix resin is dissolved is used, it is preferred since the solvent does not have to be replaced after production of the core-shell particles and therefore productivity is increased.

Among solvents, use of THFA is preferred since the layer tends to be formed compactly on the surface of the metal. A pH of a 1 wt% aqueous solution of THFA is 3, and THFA also has a property as an acid organic material in the present invention and it is thought to react with the surface of the metal to form a salt. Accordingly, it is thought that THFA supplements a reaction in which another acid organic material forms a salt with the metal and a more compact layer is formed. Further, ultrapure water is often inferior in affinity for phosphoric acid and most of the acid organic materials and it cannot mix the acid organic material in a high concentration. On the other hand, since the acid organic material easily coordinates to the surface of the metal in a reaction liquid and therefore a reaction of forming a layer easily proceeds, it is preferred.

In the present technology, a silane coupling agent may be contained in the reaction system. When the silane coupling agent exists, it is preferred since adhesion between the metal and the layer is enhanced and insulation properties of a material are improved. Since a reaction system is acidic, in order to enhance the adhesion between the surface of the metal and the layer, it is more preferred to use a basic silane coupling agent. Examples of the basic silane coupling agent include N-2-(aminoethyl)-3-aminopropyltrimethoxysilane,
3-aminopropyltrimethoxysilane,
3-mercaptopropylmethyldimethoxysilane,
3-mercaptopropyltrimethoxysilane, and
3-isocyanatepropyltriethoxysilane. Further, imidazole silanes "IM-1000" and "IS-1000 are also basic and can be preferably used.

In the present technology, a polymerization initiator may be contained in the reaction system. When the polymerization initiator exists, it is preferred since it is possible to promote a reaction in which the metal surface and the acid organic material form the organic acid salt or a reaction in which the metal surface and the phosphoric acid form phosphate and polymerization of the acid organic material or the matrix resin, and the formed layer becomes more robust. Examples of the polymerization initiator include a thermal polymerization initiator which is activated by heating and a photopolymerization initiator which is activated by light irradiation.

When an acid organic material having a polymerizable group is used, or when a polymerizable group-containing resin is further contained, the polymerization initiator used in the present technology can be selectively used depending on the type of those polymerizable groups. For example, when the polymerizable group is an acrylate group, since the acrylate group can be polymerized by radical polymerization or cationic polymerization, the polymerization initiator to be used is preferably a compound to generate a radical or a cation by activation. Further, when the polymerizable group is an epoxy group, since the epoxy group can be polymerized by cationic polymerization or anionic polymerization, the polymerization initiator to be used is preferably a compound to generate a cation or an anion by activation.

Examples of the photopolymerization initiator to generate a radical by light irradiation include oxime type, alkylphenone type, benzophenone type, acylphosphine oxide type, triazine type and benzotriazole type, and specific examples thereof include "IRGACURE 207", "IRGACURE 369", "IRGACURE 651", "IRGACURE 819", "IRGACURE 907", "DARCURE TPO" and "IRGACURE OXE01" manufactured by Ciba Japan K.K. Further, examples of the photopolymerization initiator to generate a cation by light irradiation include phosphonium type, sulfonium type and iodonium type, and specific examples thereof include "UVI-6992" manufactured by DOW CHEMICAL JAPAN LTD.

In order to disperse the metal particles without agglomerating them, a dispersant may be contained in the reaction system.

Next, the process of forming a layer on the surface of the metal particle will be described in detail. In addition, the following description is just an example, and the process of present invention is not limited to these.

First, the acid organic material or phosphoric acid, the solvent, and as required, the matrix resin, an ultraviolet absorber, the polymerization initiator, a polymerization inhibitor, and the silane coupling agent are mixed. Hereinafter, the resulting mixture is referred to as a "mixture for forming a layer".

Next, using the prepared mixture for forming a layer, a layer is formed on the surface of the metal particle to produce a core-shell particle. In order to produce an insulating material with dispersed metal particles by use of the core-shell particles, for example, the following operation is carried out. However, the following is just an example and the operation is not limited to this.

First, metal particles, as core particles, are prepared. The metal particles may be subjected to cleaning or a surface treatment prior to shell formation. Examples of a cleaning procedure include acid cleaning, alkali cleaning and organic cleaning. As the surface treatment, a treatment by a silane coupling agent is preferred since it can enhance adhesion between the metal particle and the shell to form a compact shell. As a treatment by the silane coupling agent, there is, for example, a process in which metal particles are put in ultrapure water in which a silane coupling agent is dissolved in an amount of 1 wt%, and the resulting mixture is sufficiently stirred and left to stand to settle the metal particles. Then, a cake-like metal particle, which remains after removing a supernatant liquid, is heated at 100°C for 1 hour in an oven to combine the silane coupling agent with the surface of the metal particle.

Then, the metal particles are mixed in the mixture for forming a layer to allow the metal particle to react with the acid organic material at room temperature or while heating.

In the process for forming a layer on the surface of the metal described in present specification, the acid organic material or phosphoric acid reacts with the surface of the metal to form an organic acid salt or phosphate, and this process is different in a mechanism of forming a layer from a conventional process in which a resin is polymerized by activating the polymerization initiator by heat. In the conventional process, a resin might be polymerized at an area other than the surface of the metal particle during a reaction, and thereby particles were agglomerated or viscosity of a liquid increased. On the other hand, in the technology described in the present specification, the layer is selectively formed only on the surface of the metal, and therefore the above detriment can be suppressed. Further, in the conventional process for production of core-shell particles, it is required to sufficiently stir the particles in a relatively large amount of a reaction liquid in order to suppress the agglomeration between the particles or an increase in viscosity of a liquid during the reaction, but in the technology described in the present specification, there is not such constraints. In the present technology, a compact shell can be formed by gently stirring the metal particles in a relatively small amount of a reaction solution. This is considered to be due to the following that if the particles are vigorously stirred and move too fast in a large amount of a reaction liquid, an organic acid salt or phosphate produced by the reaction around the surface of the metal peels off from the surface of the particle by a frictional force between the metal particle and the reaction liquid.

With respect to a mixing proportion between the metal particles and the mixture for forming a layer, a mixed amount of the metal particles is preferably 5 vol% or more and 40 vol% or less of a total amount of the mixture. When the mixing proportion is within the above range, movement of the particle is moderately controlled while the reaction liquid maintains moderate fluidity, and the acid organic material or phosphate is sufficiently supplied to the surface of the metal particle to form a compact shell. In addition, the total amount of the mixture refers to an amount of all of not only the metal particles and the acid organic material or phosphoric acid, but also the solvent and substances contained as required.

Examples of the method of stirring the reaction liquid include a method of rotating a container itself, and a method of stirring the reaction liquid by use of a rotational blade with a container fixed. In the case of rotating a container itself, a circumferential speed of a wall surface of the container is preferably 1 m/min or more and 50 m/min or less. When the circumferential speed is within the above range, mixing of the mixture is sufficient while movement of the particle is moderately limited, and a compact shell is formed. Examples of an apparatus of rotating a container itself include a rotary evaporator, a rotary shaker, and ball milling stand. When a container is fixed and a rotational blade is used, a circumferential speed of a tip of the rotational blade is preferably 1 m/min or more and 50 m/min or less. The reason for this is the same as the reason for a preferable range of a circumferential speed in the case of rotating the container itself.

Examples of the method of forming a compact shell include, in addition to a method of rotating a container itself or a rotational blade at a constant speed, a method of rotating them intermittently. It is effective, for example, to perform, several times, a process that the container is rotated at a circumferential speed of 50 m/min for 1 minute and then left to stand for 15 minutes.

The reaction between the metal and the acid organic material or phosphoric acid may be inhibited by oxygen, and therefore it is preferred to inject an inert gas such as nitrogen into the reaction system in such a case since the inert gas injection enables the reaction to proceed quickly. Examples of the method of evaluating a state of the formation of the shell of the particle after treatment include a method in which the shell formed on the surface of the particle is directly observed by a SEM or TEM. Further, by performing these evaluations on the particle sampled during the reaction, a temperature and a time in the forming of the shell can be appropriately determined.

The thickness of the shell to be formed is preferably 10 nm or more and 10 µm or less. When the thickness of the shell is 10 nm or more, a current hardly flows between adjacent metal particles and insulation property of the cured product is excellent in producing a cured product of an insulating material formed by mixing the core-shell particles in the matrix resin. Further, the affinity of the shell for the matrix resin is increased, and dispersibility of the particles in the insulating material is improved, and uniformity of the cured product is favorable. When the thickness of the shell to be formed is 10 µm or less, since a density of the particle in the matrix resin can be high, properties originated from the metal particle, for example, a large thermal conductivity or a large magnetic permeability of the cured product of the insulating material, can be enhanced.

The shell formed by the present technology has a network structure as shown in a SEM image of a section in Fig. 3. As the network structure is more compact, it is preferred since properties such as the insulation property and the thermal conductivity of a cured product of the insulating material with dispersed metal particles using the core-shell particles are favorable. The shell to be formed is more compact, for example, when a pretreatment by the silane coupling agent is applied to the metal particles, or when the mixed amount of the metal particles in the mixture for forming a layer is increased.

When a temperature during producing the core-shell particle is raised, a rate of shell formation increases and productivity is increased. However, since a film thickness of the shell may be uneven for some types of the metal and the acid organic material to be used, in such a case, it is often effective to employ more mild conditions, for example, a temperature during a reaction is lowered or a concentration of the acid organic material or phosphoric acid is decreased.

Next, the produced core-shell particles are mixed in the matrix resin to produce a paste-like insulating material with dispersed metal particles. After producing the core-shell particles, the core-shell particles drawn out from the mixture for forming a layer may be mixed in the matrix resin, or a lipophilic solvent, in which the matrix resin is easily dissolved, may be used during producing the core-shell particle, and after producing the core-shell particles, the matrix resin may be mixed in the mixture for forming a layer to form the insulating material with dispersed metal particles. Further, the matrix resin may be put in the mixture for forming a layer in producing the core-shell particle, or an unreacted acid organic material may be used as a matrix resin.

When the solvent, the unreacted acid organic material or phosphoric acid in the mixture after producing the core-shell particles are removed to draw out the core-shell particles, procedure is as follows. First, a solvent is mixed in the reacted mixture and the resulting mixture is adequately stirred. Examples of the solvent include ultrapure water, acetone, ethanol, isopropanol, methyl ethyl ketone, and butyl acetate. Then, the stirred mixed liquid is left to stand or centrifuged to settle the core-shell particles, and the supernatant liquid is removed. Alternatively, the mixed liquid is filtered to draw out only the core-shell particles. As required, a solvent is added to the core-shell particles again, and the mixed liquid is stirred, and then the core-shell particles are drawn out in the same manner. After the core-shell particles are cleaned several times in such a way, finally the mixed liquid from which the supernatant liquid is removed or the core-shell particles separated by filtration are dried and drawn out. The shell may be further polymerized/cured by subjecting the core-shell particles drawn out to heating or ultraviolet irradiation.

With respect to a mixing proportion between the core-shell particles and the matrix resin, a mixed amount of the core-shell particles is preferably 10 vol% or more and 90 vol% or less with respect to a volume of a total solid content of the core-shell particles, the matrix resin and the like in the insulating material with dispersed metal particles. When the mixed amount of the core-shell particles is 10 vol% or more with respect to a volume of a total solid content of the insulating material with dispersed metal particles, properties originated from the metal particle, for example, a large thermal conductivity or a large magnetic permeability of the cured product of the obtained insulating material with dispersed metal particles, can be enhanced. Further, when the mixed amount of the core-shell particles is 90 vol% or less with respect to a volume of a total solid content of the insulating material with dispersed metal particles, the cured product of the obtained insulating material with dispersed metal particles is tough and cracks are hardly produced.

Examples of the matrix resin include thermosetting or ultraviolet-curable resins having a polymerizable group such as polyamic acid, vinyl resin, norbornene resin, epoxy resin, acrylate resin, epoxy-acrylate resin, cyanate resin, bismaleimide-triazine resin, benzocyclobutene resin and siloxane resin. Also, examples of the resin include thermoplastic resins such as aramid resin, polystyrene, polyetherimide, polyphenylene ether and thermoplastic polyimide.

As the core-shell particle to be mixed, core-shell particles produced from plural types of metal particles different in material may be used, or core-shell particles produced from metal particles different in particle diameter may be used. When the core-shell particles different in particle diameter are used, it is preferred since a small particle penetrates into the gap between large particles and therefore a packing fraction of particles can be increased.

In addition to the core-shell particles and the matrix resin, the solvent or the dispersant, the photopolymerization initiator, the thermal polymerization initiator, the polymerization inhibitor, the ultraviolet absorber, a surfactant, the silane coupling agent, an adhesion aid, other metal particles, or particles of metal compounds such as metal oxide, metal nitride and metal carbide may be added as required.

Next, a process of producing a sheet-like dry film (uncured film) from a paste-like insulating material with dispersed metal particles, which is produced by using the above core-shell particles and a matrix resin, will be described. First, the paste-like insulating material with dispersed metal particles is applied onto a film substrate by using a bar coater, a blade coater, or a comma coater. Examples of a material of the film substrate include PET, polyimide, and polypropylene. When a film with a releasing agent of silicon applied to the surface thereof (release film) is employed, it is preferred since the film substrate can be easily peeled and removed when using the sheet-like insulating material with dispersed metal particles. Examples of the release film include "SR-1" produced by OHTSUKI INDUSTRIAL CO., LTD. and "Cerapeel" produced by TORAY ADVANCED FILM Co. , Ltd. Then, the insulating material with dispersed metal particles applied onto the film substrate is dried by an oven, and a protective film is bonded to the dried film as required to obtain a sheet-like uncured insulating material with dispersed metal particles. A film subjected to releasing-treatment as with the above film substrate can also be used for the protective film.

Examples of use of the insulating material with dispersed metal particles will be described blow. In addition, the following description is just an example, and a method of use is not limited to this. First, a paste-like insulating material with dispersed metal particles is applied onto a circuit board, and dried to obtain an uncured product of the insulating material with dispersed metal particles. Examples of the substrate include various substrates used as an electronic circuit board such as a silicon substrate, a ceramic substrate, a glass-epoxy substrate, and a polyimide film, and conductive wiring of a metal or the like, other insulating layers or semiconductor devices may exist on the substrate. Examples of the application method include falling-drop, bar coating, spin coating, screen printing and dip coating. Alternatively, the above sheet-like insulating material with dispersed metal particles can be bonded to the substrate. This bonding can be carried out at room temperature or at moderate temperature by using a roll laminator or a vacuum laminator.

Next, an uncured film of the insulating material with dispersed metal particles formed on the substrate is subjected to polymerization/curing treatment such as heating or ultraviolet irradiation to form a cured product of the insulating material with dispersed metal particles. Conditions of polymerization/curing treatment of materials are appropriately set in accordance with a material composition or a production process of a circuit board. When the insulating material with dispersed metal particles is one which contains a photopolymerization initiator and polymerizes a matrix resin by light irradiation such as ultraviolet irradiation, after the insulating material with dispersed metal particles is formed on the substrate, the material can also be patterned by a photolithography process.

The cured product of the insulating material with dispersed metal particles has good insulation properties because a shell exists at an interface between the metal particle and the matrix resin and thereby formation of a conductive path due to connection between the metal particles is suppressed. Further, adhesion between the metal particle and the matrix resin is good and the occurrence of voids or cracks is suppressed. Further, in the core-shell particles produced by the present technology, since there is little coarse particle formed by agglomeration between particles, the particles can be filled uniformly and in a large number in the insulating material. Accordingly, since properties of the used metal is imparted well to the insulating material, a material in which silver or copper is used as a metal particle can be used as a high thermal conductivity material, and a material in which iron is used as a metal particle can be used as a high magnetic permeability material. Further, since the metal particle has a lower linear expansion coefficient than that of a resin, its use for various insulating materials in the electronic circuit board is preferred because problems of cracks or peeling due to heat are reduced.

On the other hand, since the core-shell particles produced by the present technology have good dispersibility in a resin, the amount of a binder resin can be reduced when a sintered type conductive paste is produced by use of the core-shell particles and a binder resin. Therefore, when the binder resin and the shell are burned off in a firing step after applying the paste, the metal particles can be firmly joined to one another to form a metal wiring having good electrical conductivity.

The present technology can be applied to not only the production of the core-shell particle but also a cover of the metal wiring on the circuit board or a metal joint area. Hitherto, there is known a technology in which after a device in electronic equipment is joined to a metal joint area on the circuit board, the joint area or other exposed metal wiring is covered with a resin layer to secure insulation reliability (e.g., Japanese Unexamined Patent Publication No.2008-31335).

An underfill covering a metal joint area between the semiconductor device and the circuit board is used for enhancing insulation properties and joint strength of the joint area, but since it has a larger linear expansion coefficient than that of the semiconductor device, there is a problem that in a thermal cycle test, cracks are produced in the joint area or the joint area is broken due to thermal expansion of the underfill itself. When the substrate is a resin-containing substrate such as a glass-epoxy substrate, the substrate might mitigate the stress due to thermal expansion of the underfill to suppress the above-mentioned problem, but when the substrate is an inorganic substrate such as a glass substrate or a silicon substrate, the stress tends to concentrate in the joint area as-is to cause cracks.

If the present technology is applied to the underfill, since the underfill covers only the metal joint area, an amount of the underfill existing ultimately at the joint area can be reduced as compared with a conventional underfill. Therefore, the cracks by thermal expansion of the underfill described above can be suppressed.

Further, with an increase of more fine joint pitch, it is required to penetrate an applying liquid of the underfill into a gap between the semiconductor device and the substrate through a clearance between close joint areas. For this, it is necessary to decrease the viscosity of the applying liquid, but there might be cases where the underfill was run over out of the joint area beneath the semiconductor device and spread on an upper area of the semiconductor device and to a wide area on the substrate while being applied. Therefore, an excessive amount of a covering resin is formed, an occupancy space of a mounting substrate could increase, or bending of a flexible substrate could become difficult.

In accordance with the present technology, even if the underfill spreads on an upper area of the semiconductor device and to a wide area on the substrate while being applied, since the layer is not formed in an area other than the metal surface, the underfill·can be removed. Accordingly, a volume and a weight of the circuit board can be reduced to realize smaller and lighter electronic equipment.

In order to cover the metal wiring or the metal joint area with the mixture for forming a layer, the following operation is carried out. First, the mixture for forming a layer is applied to the metal area so as to cover the metal area to be covered such as the metal wiring or the metal joint area on the substrate. Examples of the application method include direct application methods such as falling-drop, bar coating, spin coating, screen printing and dip coating; and a method in which the mixture is applied onto a film substrate once and then transferred. Particularly, when the mixture is applied onto the joint area of the semiconductor device such as IC and the substrate, a method of falling-drop is preferred.

Then, the substrate with the mixture for forming a layer applied is maintained at a predetermined temperature for a given time to be dried and to allow the reaction between the acid organic material or phosphoric acid and the metal to proceed, and thereby the organic acid salt or phosphate is produced. In this time, the produced organic acid salt takes in the acid organic material not directly involved in the reaction with the metal or other resin existing in the mixture to form a layer. As with the production of the core-shell particle, the reaction occurs only in the metal wiring or the metal joint area. However, since a film thickness of the layer may be uneven for some types of the metal, the acid organic material to be used and other resins, in such a case, it is often effective to employ more mild conditions, for example, a temperature during a reaction is lowered or a concentration of the acid organic material or phosphoric acid is decreased.

After forming the layer, compounds such as an unreacted acid organic material or phosphoric acid is cleaned away with a solvent, and a substrate in which the metal wiring or the metal joint area is covered with the layer is obtained. Examples of the cleaning solvent include organic solvents such as acetone, ethanol, isopropanol, methyl ethyl ketone, and butyl acetate; and an aqueous solution of tetramethylammonium hydroxide. In accordance with this process, the layer is formed selectively only in the metal wiring and the metal joint area, and thus an unreacted material in an area other than these is easily cleaned.

After removing the mixture for forming a layer in an area other than the metal, in order to further promote polymerization/curing of the layer, heating and ultraviolet irradiation may be further applied.

When the present technology is used to selectively form a layer only in the metal area to be covered, heat stress by a difference in linear expansion coefficient between the substrate and the layer can be reduced, and cracks or breaks of the metal joint area can be suppressed. Further, since the amount of the layer to be formed can be reduced, a volume and a weight of the circuit board can be reduced to realize smaller and lighter electronic equipment.

### EXAMPLES

Hereinafter, examples of the present invention will be described, but the present invention is not limited to these examples.

Materials used in the present invention are described below.

### <Metal Particle>

- Copper particle "MA-C08J" (average particle diameter: 8.0 µm, manufactured by MITSUI CHEMICALS, INC.)
- Silver particle "SPQ05S" (average particle diameter: 0.82 µm, manufactured by MITSUI CHEMICALS, INC.)
- Iron particle "Fe(HQ)" (average particle diameter: 2.0 µm, manufactured by BASF Japan Ltd.)

### <Acid Organic Material>

- Phosphate-containing acrylate "P-1M" (manufactured by KYOEISHA CHEMICAL Co., Ltd.)
- Carboxyl group-containing acrylate "HOA-MPL" (manufactured by KYOEISHA CHEMICAL Co., Ltd.)
- Carboxyl group-containing acrylate "HOA-MS" (KYOEISHA CHEMICAL Co., Ltd.)
- Resin A (carboxyl group-containing acrylate represented by the following formula (1), manufactured by KYOEISHA CHEMICAL Co., Ltd.)

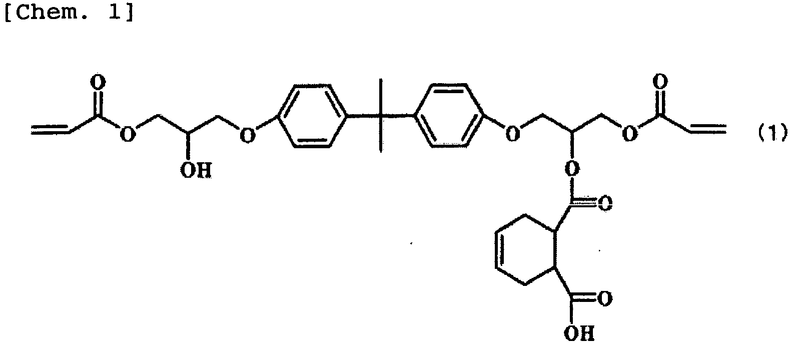

<Other Resin>
- Epoxy group-containing acrylate "LIGHT ESTER G" (KYOEISHA CHEMICAL Co., Ltd.)
- Polypropylene glycol diacrylate "APG-700" (manufactured by Shin-Nakamura Chemical Co., Ltd)
- Bisphenol A epoxy resin "jER 828" (manufactured by Japan Epoxy Resins Co. Ltd.)

### <Polymerization Initiator>

- Thermal polymerization initiator "Curezol 2PZ" (manufactured by SHIKOKU CHEMICALS CORPORATION)

### <Solvent>

- Ultrapure water
- Tetrahydrofurfuryl alcohol (THFA)
- Propylene glycol monomethylether acetate (PGMEA)
- γ-butyrolactone (GBL)

### <Silane Coupling Agent>

- KBM603 (manufactured by Shin-Etsu Chemical Co., Ltd., chemical name: N-2-(aminoethyl)-3-aminopropyl trimethoxysilane)
- KBM 403 (manufactured by Shin-Etsu Chemical Co., Ltd., chemical name: 3-glycidoxypropyltrimethoxysilane)
- KBM 503 (manufactured by Shin-Etsu Chemical Co., Ltd., chemical name: 3-methacryloxypropyltrimethoxysilane)

Evaluation methods of properties of a core-shell particle formed by forming a shell on the surface of a metal particle and a cured product of an insulating material with dispersed metal particles using the core-shell particle are as follows.

### <Evaluation Methods of Form and Thickness of Shell in Core-Shell Particle>

The shell of the core-shell particle was observed at its surface and at its cross section using a scanning electron microscope (SEM) "S-4800" (manufactured by Hitachi Ltd.). As a pretreatment for observation of a cross section, a cross section of the core-shell particle was prepared by ion milling, and the cross section was subjected to a conduction treatment (Pt coating). Further, in the observation of the cross section, thicknesses of the shells of arbitrary ten particles were measured and an average of ten measurements was taken as a thickness of the shell. Here, the thickness of the shell of each particle was an average of the thickness values measured at eight points approximately equally spaced on a periphery of the particle.

### <Evaluation Method of Insulation Reliability of Cured Product of Insulating Material with Dispersed Metal Particles>

The insulation reliability of a cured product of the insulating material with dispersed metal particles was evaluated by a load test under high temperature and high humidity conditions. An insulation reliability test sample was prepared as follows.

First, on a silicon substrate with a thermal oxide film having a thickness of 0.4 µm and a SiNx film having a thickness of 0.8 µm, Cr (thickness 0.08 µm)/Cu (thickness 0.25 µm) are laminated in this order as an electrode material, and a substrate with a copper comb teeth-shaped electrode, in which line and space (L/S) are formed in a comb teeth shape of 10 µm/10 µm, was prepared.

A sample, in which a film comprising a cured product of the insulating material with dispersed metal particles is formed on the substrate with a copper comb teeth-shaped electrode, was prepared. The sample was placed in a high temperature and high humidity chamber in which a temperature and a humidity were set at 85°C and 85% RH, respectively, and a voltage was applied between both ends of the comb teeth-shaped electrode after a lapse of five minutes from the stabilization of environment in the chamber and a change of insulation resistance over time was measured for 1000 hours. An application voltage was 20 volts. The resistance value was read out every 5 minutes to measure the change of insulation resistance over time. The time when the resistance value reached less than 10⁸ Ω was considered as a retention time of insulation reliability and recorded. Further, a retention time of insulation reliability of the sample which retained a resistance value of 10⁸ Ω or more for 1000 hours or more was taken as 1000 hours.

### <Evaluation Method of Volume Resistivity and Withstand Voltage of Cured Product of Insulating Material with Dispersed Metal Particles>

A cured product of the insulating material with dispersed metal particles was formed on a silicon substrate with a Cr film so as to be 100 µm in thickness, and an Al electrode (electrode area 1 cm²) was vapor-deposited on the cured film. A DC voltage of 5 volts was applied between the Al electrode and the silicon substrate with a Cr film, and a volume resistivity was determined from a resistance value at the time of applying a voltage of 5 V, and a film thickness of a material. Measurement was carried out by use of an insulation resistance tester "6517A" (trade name, manufactured by Keithley Instruments Inc.).
Further, using this tester, the DC application voltage was gradually increased, and a voltage at which resistance reached zero was read out and this voltage value was defined as a withstand voltage of a material.

### Example 1

An acid organic material "resin A", THFA, and a silane coupling agent "KBM 503" were mixed in a weight ratio of 10 : 90 : 1 to prepare a mixture for forming a layer. Then, a drop of the prepared mixture was dropped with a dropper on a silicon substrate with a copper film formed on the surface thereof by a sputtering method, and the substrate was heated at 90°C for 1 hour on a hot plate. The heated substrate was immersed in acetone for 30 seconds, cleaned with ultrapure water, and dried at 90°C for 15 minutes. It was confirmed that a layer was formed on the dried substrate.

Moreover, using a silicon substrate with a silver film formed on the surface thereof by a sputtering method, a silicon substrate with a gold film formed on the surface thereof by a sputtering method, a silicon substrate with a tin film formed on the surface thereof by a sputtering method, an aluminum plate, a stainless steel plate, a zinc plate and a solder (tin: 60%, lead: 40%) plate as the substrate, the same treatment was performed, and consequently it was confirmed that a layer was formed on the dried substrate in all the substrates.

### Comparative Example 1

Using a silicon substrate, a glass substrate, a glass-epoxy substrate, and a polyimide film as the substrate, the same treatment as in Example 1 was performed, and consequently the formation of a layer on the dried substrate could not be found in all the substrates.

### Example 2

10 g of copper particles "MA-C08J", 10 g of ultrapure water and 0.1 g of a silane coupling agent "KBM 603" were mixed, stirred, and then transferred to a cup made of aluminum, and the cup was left standing to allow the copper particles to settle out. After a supernatant liquid was removed, the resultant was heated at 100°C for 1 hour to perform pretreatment of the copper particles.

0.1 g of phosphoric acid and 5 g of ultrapure water were mixed and stirred to prepare a mixture for forming a layer. In addition, a pH of an aqueous solution (denoted by "1 wt% aqueous solution" in Table, same as above) formed by mixing 0.1 g of phosphoric acid with 9.9 g of ultrapure water was 1.8. The pH was measured by use of a pH meter "CyberScan pH310" (manufactured by EUTECH INSTRUMENT Pte Ltd.).

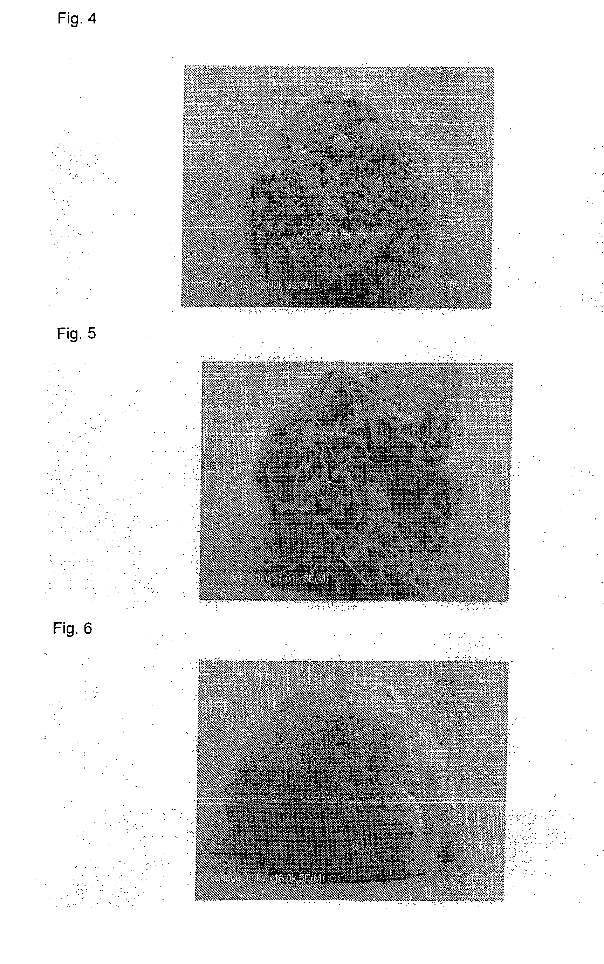

Next, the mixture for forming a layer was put in a 100 ml eggplant flask, and to this, 10 g of the pretreated copper particles was added (amount of the mixed metal particles: 18 vol%) and a container (flask) was rotated for 3 hours in a water bath of 45°C, using a rotating/mixing function of a rotary evaporator. A rotational speed during the treatment was 100 rpm (a circumferential speed at a wall surface of the container: 19 m/min). A sample of a reaction liquid after treatment was taken out, put into a sample bottle and left to stand, and a supernatant liquid was removed. Then, ultrapure water was added, and the resultant was stirred to clean the particles, and after leaving the particles to stand, a supernatant liquid was removed. Once more, the particles were cleaned with ultrapure water and left to stand, and a supernatant liquid was removed, and finally the particles were dried to obtain core-shell particles. The obtained particles were observed with a SEM, and consequently it was found that network shells were compactly formed on the surfaces of copper particles (Fig. 4). A thickness of the shell was 0.8 µm.

Then, 5 g of the core-shell particles was taken out and put into a sample bottle, and to this, 0.56 g of the resin A represented by the formula (1) as a matrix resin and 0.7 g of THFA were added and stirred to produce a paste-like insulating material with dispersed metal particles. This insulating material was applied onto the substrate with a copper comb teeth-shaped electrode for evaluation of insulation reliability, and dried at 90°C for 30 minutes in the air, and then heat treated at 200°C for 1 hour in a nitrogen atmosphere to polymerize and cure a matrix resin. The resistance value of the resulting sample in a load test under high temperature and high humidity conditions retained 10⁸ Ω for 1000 hours or more.

Next, the paste-like insulating material with dispersed metal particles was applied onto a release film "SR-1" (manufactured by OHTSUKI INDUSTRIAL CO.,LTD) so as to be 100 µm in film thickness by use of a bar coater and dried at 90°C for 30 minutes in the air. A silicon substrate with a Cr film was placed on a hot plate of 130°C, and the obtained dried film was bonded to the substrate with a hand roller and adequately cooled, and thereafter the release film was peeled off. Then, the resultant was cured at 200°C for 1 hour in a nitrogen atmosphere to cure a matrix resin. A sample had a volume resistivity of 7.8 x 10⁹ Ω and a withstand voltage of 320 V.

Next, the paste-like insulating material with dispersed metal particles was applied onto a release film "SR-1" (manufactured by OHTSUKI INDUSTRIAL CO.,LTD) so as to be 100 µm in film thickness by use of a bar coater and dried at 90°C for 30 minutes in the air. Subsequently, the dried film was peeled off from the release film and then heat treated at 200°C for 1 hour in a nitrogen atmosphere to polymerize and cure a matrix resin. The thermal conductivity of the resulting sample was measured by use of a thermal conductivity measuring apparatus "HC-110" (manufactured by EIKO INSTRUMENTS CO. , LTD.), and the thermal conductivity was 4.6 W/m·K.

### Example 3

Core-shell particles and a paste-like insulating material with dispersed metal particles were produced as in Example without carrying out the pretreatment in which the silane coupling agent was used for the copper particles. The evaluation results are shown in Table 2. Further, a SEM image of a core-shell particle is shown in Fig. 5. A network of the shell of the core-shell particle was rough compared with that of the core-shell particle produced in Example 2.

### Examples 4 to 10

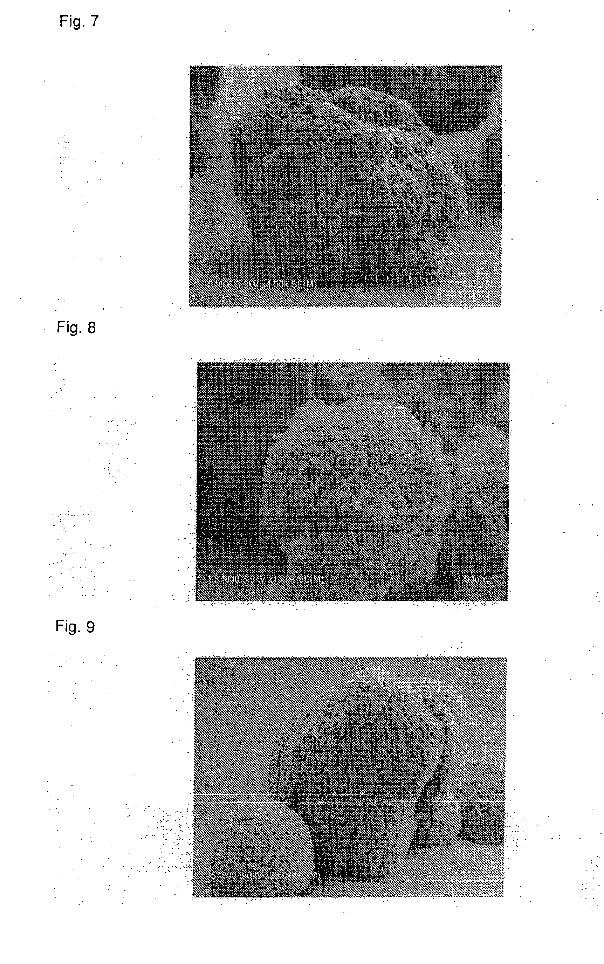

Core-shell particles and a paste-like insulating material with dispersed metal particles were produced as in Example 2 except for changing the amounts of the copper particle and the ultrapure water in the mixture for forming a layer to those shown in Table 1. The evaluation results are shown in Table 2. Further, SEM images of core-shell particles produced in Examples 6 and 10 are shown in Figs. 6 and 7, respectively. A network of the shell of the core-shell particle produced in Example 6 was fine compared with that of the core-shell particle produced in Example 2, and a network of the shell of the core-shell particle produced in Example 10 was rough compared with that of the core-shell particle produced in Example 2.

### Examples 11 to 13

Core-shell particles and a paste-like insulating material with dispersed metal particles were produced as in Example 3 except for changing the composition of the mixture for forming a layer to that shown in Table 1. The evaluation results are shown in Table 2.

### Examples 14 to 15

Core-shell particle and a paste-like insulating material with dispersed metal particles were produced as in Example 2 except for carrying out the pretreatment of the copper particle by use of a compound shown in Table 1. The evaluation results are shown in Table 2.

### Examples 16 to 28

Core-shell particles and a paste-like insulating material with dispersed metal particles were produced as in Example 2 except that a compound shown in Table 1 was added to the mixture for forming a layer as an acid organic material and the amount of the ultrapure water was changed to that shown in Table 1. The evaluation results are shown in Table 2. Further, a SEM image of a core-shell particle produced in Example 17 is shown in Fig. 8. However, in Example 19, the pretreatment in which the silane coupling agent is used for the copper particle was not carried out.

### Examples 29 to 41

Core-shell particles and a paste-like insulating material with dispersed metal particles were produced as in Example 2 except that the composition of the mixture for forming a layer was changed to that shown in Table 3 and a process temperature of core-shell particle production was changed to that shown in Table 3. The evaluation results are shown in Table 4. Further, a SEM image of a core-shell particle produced in Example 31 is shown in Fig. 9. However, in Examples 29 and 33, the pretreatment in which the silane coupling agent is used for the copper particle was not carried out.

### Example 42

Core-shell particles and a paste-like insulating material with dispersed metal particles were produced as in Example 38 except that in process conditions in the core-shell particle production, a cycle of shaking/mixing a container for 1 minute and then leaving the container to stand for 14 minutes in a water bath of 80°C was repeated for 3 hours without using the rotary evaporator. The evaluation results are shown in Table 4.

### Examples 43 to 44

Core-shell particles and a paste-like insulating material with dispersed metal particles were produced as in Example 2 except that the metal particle was changed to a silver particle "SPQ05S", the composition of the mixture for forming a layer was changed to that shown in Table 3 and a process temperature of core-shell particle production was changed to that shown in Table 3. The results of evaluations of these are shown in Table 4.

### Example 45

Core-shell particles were produced as in Example 3 except for changing the metal particle to an iron particle "Fe(HQ)". The obtained particles were observed with a SEM, and consequently it was found that compact shells were formed on the surfaces of iron particles. A thickness of the shell was 0.7 µm.

Next, a paste-like insulating material with dispersed metal particles was produced as in Example 2 using the core-shell particles, and a load test under high temperature and high humidity conditions was carried out, and consequently resistance of the insulating material retained. 10⁸ Ω for 1000 hours or more. Further, a volume resistivity and a withstand voltage of the insulating material were measured as in Example 2, and consequently they were 6.0 x 10¹⁰ Ω and 420 V, respectively.

Next, the paste-like insulating material with dispersed metal particles was applied onto a glass substrate so as to be 15 µm in film thickness and dried at 90°C for 30 minutes in the air, and then heat treated at 200°C for 1 hour in a nitrogen atmosphere to polymerize and cure a matrix resin. A specific magnetic permeability of the resulting sample was measured by use of a high frequency permeability measuring apparatus for thin film (manufactured by Toei Scientific Industrial co., Ltd.), and it was 2.2 at an alternate-current magnetic field of 100 MHz.

### Example 46

Core-shell particles and a paste-like insulating material with dispersed metal particles were produced as in Example 45 except that the composition of the mixture for forming a layer was changed to that shown in Table 3 and a process temperature of core-shell particle production was changed to that shown in Table 3. The evaluation results are shown in Table 4.

### Example 47

0.1 g of an acid organic material "HOA-MS", 0.01 g of a photopolymerization initiator "IRGACURE 819", and 10 g of THFA were mixed and stirred to prepare a mixture for forming a layer.

Next, the mixture for forming a layer was put in a 200 ml eggplant flask, and to this, 0.5 g of copper particles "MA-C08J" was added (amount of the mixed metal particles: 0.6 vol%), and the resultant was heated at 90°C for 3 hours by an oil bath while being stirred. 0.1 g of a sample was taken out from a reaction liquid after treatment, put into a sample bottle and left to stand, and a supernatant liquid was removed. Then, acetone was added and stirred to clean the particles, and after leaving the particles to stand, a supernatant liquid was removed. Once more, the particles were cleaned with acetone and left to stand and a supernatant liquid was removed, and finally the particles were dried to obtain core-shell particles. The obtained particles were observed with a SEM, and it was found that compact shells were formed on the surfaces of copper particles. A thickness of the shell was 120 nm.

Then, 5 g of a sample was taken out from the treated reaction liquid remaining after taking out for evaluating the shell, and put into a sample bottle, and to this, 0.25 g of the resin A represented by the formula (1) was added as a matrix resin and stirred to prepare a paste-like insulating material with dispersed metal particles. This insulating material was applied onto the substrate with a copper comb teeth-shaped electrode for evaluation of insulation reliability, and dried at 90°C for 15 minutes in the air, and then the resultant was heat treated at 200°C for 1 hour in a nitrogen atmosphere to polymerize and cure a matrix resin. The resistance value of the resulting sample in a load test under high temperature and high humidity conditions retained 10⁸ Ω for 1000 hours or more.

Next, the paste-like insulating material with dispersed metal particles was applied so as to form a flat plate of 5 mm in thickness and dried at 90°C for 30 minutes in the air, and then the resultant was heat treated at 200°C for 1 hour in a nitrogen atmosphere to polymerize and cure a matrix resin . Then, the thermal conductivity of the resulting flat plate sample was measured by use of a thermal conductivity measuring apparatus "HC-110" (manufactured by EIKO INSTRUMENTS CO. , LTD.), and the thermal conductivity was 0.5 W/m.K.

### Comparative Example 2

Copper particles not subjected to a core-shell particle production process were observed with a SEM, and no shell was found on the surfaces of copper particles.

Next, a paste-like insulating material with dispersed metal particles was produced as in Example 2, and their various physical properties were evaluated. A resistance value in a load test under high temperature and high humidity conditions was less than 10⁸ Ω after a lapse of 190 hours. Further, a volume resistivity and a withstand voltage of the insulating material were measured, and they were 5.5 × 10⁴ Ω and 10 V, respectively. A thermal conductivity was 3.0 W/m·K.

### Comparative Example 3

In the mixture for forming a layer, the acid organic material or phosphoric acid was not mixed, but a resin "LIGHT ESTER G" was mixed in place of this. A pH of a 1 wt% aqueous solution of "LIGHT ESTER G" was 4.6. By using this mixture, core-shell particles were produced as in Example 29. The obtained particles were observed with a SEM, and few shells were formed on the surfaces of copper particles, and an average layer thickness was 10 nm or less.

Next, a paste-like insulating material with dispersed metal particles was produced as in Example 2, and their various physical properties were evaluated. The evaluation results are shown in Table 4.

### Comparative Example 4

In the mixture for forming a layer, the acid organic material or phosphoric acid was not mixed, but a resin "APG-700" was mixed in place of this. A pH of a 1 wt% aqueous solution of "APG-700" was 4.2. By using this mixture, core-shell particles were produced as in Example 29. The obtained particles were observed with a SEM, and few shells were formed on the surfaces of copper particles, and an average layer thickness was 10 nm or less.

Next, a paste-like insulating material with dispersed metal particles was produced as in Example 2, and their various physical properties were evaluated. The evaluation results are shown in Table 4.

### Comparative Example 5

0.1 g of "LIGHT ESTER G", 5 g of ultrapure water and 0.005 g of a thermal polymerization initiator azobisisobutylonitrile were mixed and stirred to prepare a mixture for forming a layer.

Next, the mixture for forming a layer was put in a 100 ml eggplant flask, and to this, 10 g of copper particles "MA-C08J" was added and a container (flask) was rotated for 1 hour in a water bath of 60°C, using a rotating/mixing function of a rotary evaporator. A rotational speed during the treatment was 100 rpm (a circumferential speed at a wall surface of the container: 19 m/min). Viscosity of a reaction liquid increased during the treatment and the copper particles stuck to a wall surface of the flask. After the treatment, the copper particles firmly stuck to a wall surface of the flask were unstuck, and to this, ultrapure water was added and the resultant was stirred to clean the particles, and after leaving the particles to stand, a supernatant liquid was removed. Once more, the particles were cleaned with ultrapure water and left to stand and a supernatant liquid was removed, and finally the particles were dried to obtain core-shell particles. The obtained particles were observed with a SEM, and it was found that some particles were agglomerated, shells were formed partly on the surfaces of some particles and some particles with no shell existed, and therefore the thickness of a shell could not be determined. Moreover, polymers which do not contain copper particles and contain only a resin existed.

Next, a paste-like insulating material with dispersed metal particles was produced as in Example 2, and their various properties were evaluated. A resistance value in a load test under high temperature and high humidity conditions was less than 10⁸ Ωafter a lapse of 230 hours. Further, a volume resistivity and a withstand voltage were measured, and they were 5.9 × 10⁴ Ω and 10 V, respectively. A thermal conductivity was 3.2 W/m•K.

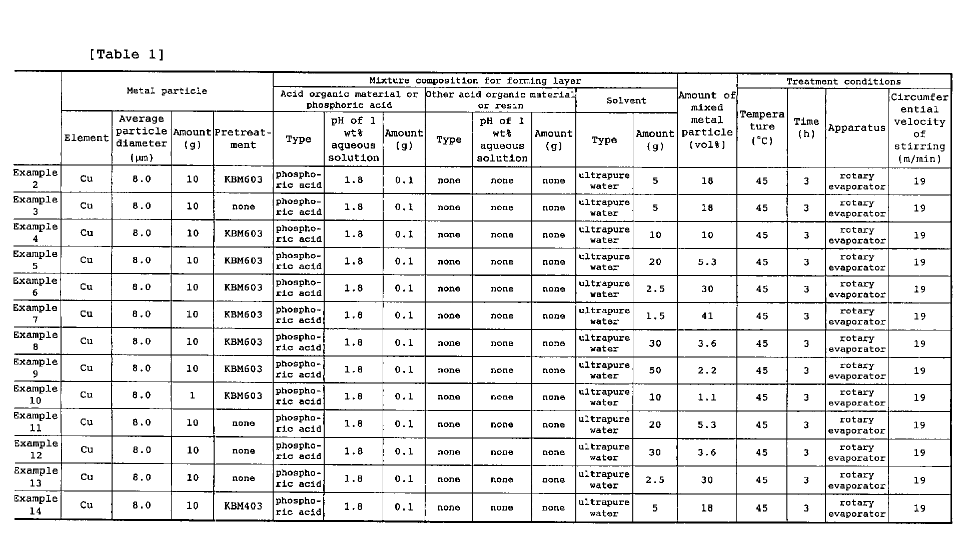

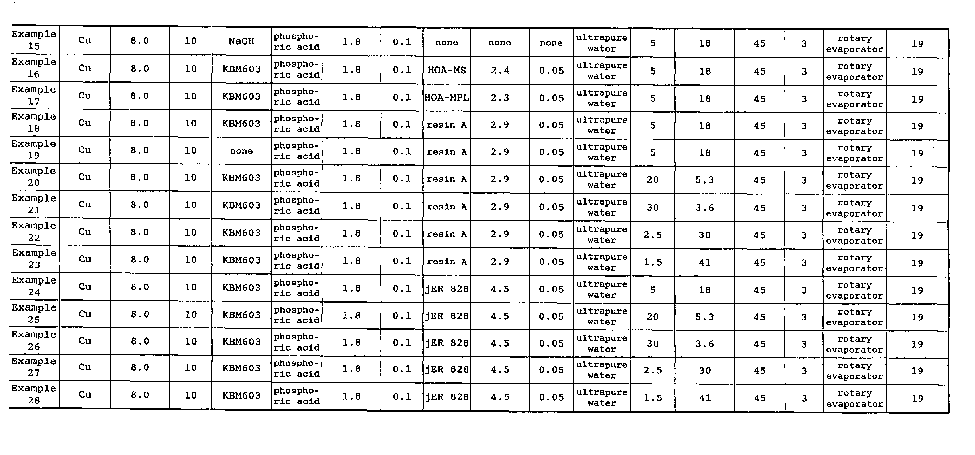

1

**[Table 2]**

| | Thickness of shell (µm) | Retention time of insulation reliability (h) | Volume resistivity (Ω•cm) | Withstand voltage (V) | Thermal conductivity (W/m•K) | Specific magnetic permeabilitiy |
|---|---|---|---|---|---|---|
| Example 2 | 0.8 | 1000 | 7.8 x 10⁹ | 320 | 4.6 | - |
| Example 3 | 3.0 | 1000 | 1.3 3 × 10⁷ | 110 | 3.5 | - |
| Example 4 | 1.0 | 1000 | 5.1 × 10⁹ | 300 | 4.5 | - |
| Example 5 | 1.2 | 1000 | 3.0 × 10⁹ | 280 | 4.5 | - |
| Example 6 | 0.3 | 1000 | 9.7 × 10⁹ | 330 | 4.7 | - |
| Example 7 | 0.2 | 1000 | 7.3 × 10⁸ | 230 | 4.3 | - |
| Example 8 | 1.9 | 1000 | 8.9 × 10⁸ | 230 | 4.2 | - |
| Example 9 | 2.0 | 1000 | 5.8 × 10⁸ | 210 | 4.1 | - |
| Example 10 | 2.1 | 1000 | 2.5 × 10⁸ | 190 | 4.1 | - |
| Example 11 | 3.0 | 1000 | 1.1 × 10⁷ | 110 | 3.6 | - |
| Example 12 | 4.0 | 1000 | 8.4 × 10⁶ | 100 | 3.5 | - |
| Example 13 | 2.5 | 1000 | 2.2 × 10⁷ | 120 | 3.6 | - |
| Example 14 | 1.5 | 1000 | 6.2 × 10⁹ | 310 | 4.6 | - |
| Example 15 | 2.8 | 1000 | 5.6 × 10⁷ | 140 | 3.7 | - |
| Example 16 | 1.1 | 1000 | 1.2 × 10¹⁰ | 340 | 4.8 | - |
| Example 17 | 0.9 | 1000 | 3.4 × 10¹⁰ | 380 | 4.9 | - |
| Example 18 | 1.1 | 1000 | 5.4 × 10¹⁰ | 400 | 5.0 | - |
| Example 19 | 1.2 | 1000 | 4.6 × 10⁸ | 210 | 4.2 | - |
| Example 20 | 1.0 | 1000 | 2.1 × 10¹⁰ | 360 | 4.8 | - |
| Example 21 | 0.9 | 1000 | 7.6 × 10⁹ | 320 | 4.6 | - |
| Example 22 | 0.4 | 1000 | 7.4 × 10¹⁰ | 420 | 5.1 | - |
| Example 23 | 0.3 | 1000 | 6.7 × 10⁹ | 320 | 4.6 | - |
| Example 24 | 1.0 | 1000 | 2.7 × 10¹⁰ | 370 | 4.8 | - |
| Example 25 | 1.0 | 1000 | 1.1 × 10¹⁰ | 330 | 4.7 | - |
| Example 26 | 1.2 | 1000 | 5.5 × 10⁹ | 300 | 4.5 | - |
| Example 27 | 0.6 | 1000 | 3.9 × 10¹⁰ | 390 | 4.9 | - |
| Example 28 | 0.4 | 1000 | 4.3 × 10⁹ | 290 | 4.5 | - |

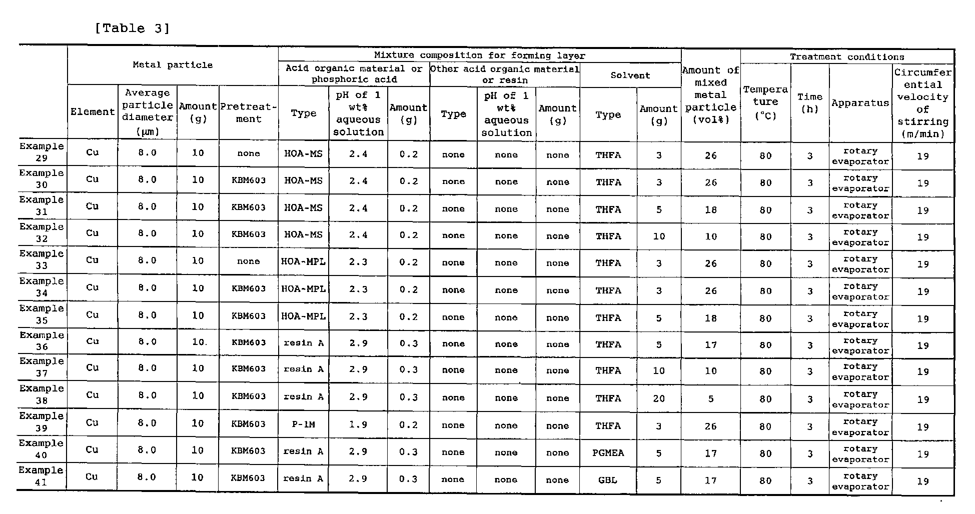

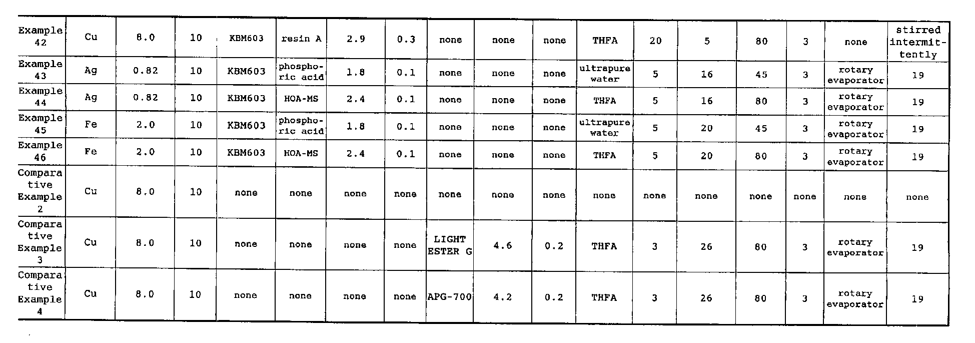

**[Table 4]**

| | Thickness of shell (µm) | Retention time of insulation reliability (h) | Volume resistivity (Ω•cm) | Withstand voltage (V) | Thermal conductivity (W/m•K) | Specific magnetic permeabilitiy |
|---|---|---|---|---|---|---|
| Example 29 | 0.2 | 1000 | 3.9 × 10⁷ | 140 | 3.7 | - |
| Example 30 | 0.2 | 1000 | 4.1 × 10⁹ | 290 | 4.5 | - |
| Example 31 | 0.2 | 1000 | 3.0 × 10⁹ | 280 | 4.5 | - |
| Example 32 | 0.2 | 1000 | 2.3 × 10⁹ | 270 | 4.4 | - |
| Example 33 | 0.1 | 1000 | 4.4 × 10⁷ | 140 | 3.7 | - |
| Example 34 | 0.1 | 1000 | 5.7 × 10⁹ | 310 | 4.6 | - |
| Example 35 | 0.2 | 1000 | 3.5 × 10⁹ | 290 | 4.5 | - |
| Example 36 | 0.1 | 1000 | 6.9 × 10⁹ | 320 | 4.6 | - |
| Example 37 | 0.1 | 1000 | 5.5 × 10⁹ | 310 | 4.6 | - |
| Example 38 | 0.1 | 1000 | 4.7 × 10⁹ | 300 | 4.5 | - |
| Example 39 | 0.2 | 1000 | 5.2 × 10⁹ | 300 | 4.5 | - |
| Example 40 | 0.1 | 1000 | 1.5 × 10⁹ | 250 | 4.4 | - |
| Example 41 | 0.1 | 1000 | 2.7 × 10⁹ | 280 | 4.5 | - |
| Example 42 | 0.2 | 1000 | 6.2 × 109 | 310 | 4.6 | - |
| Example 43 | 0.5 | 1000 | 3.8 × 10⁹ | 290 | 4.5 | - |
| Example 44 | 0.1 | 1000 | 1.6 × 10⁹ | 260 | 4.4 | - |
| Example 45 | 0.7 | 1000 | 6.0 × 10¹⁰ | 420 | - | 2.2 |
| Example 46 | 0.2 | 1000 | 2.0 × 10¹⁰ | 380 | - | 2.1 |
| Comparative Example 2 | 0 | 190 | 5.5 × 10⁴ | 10 | 3.0 | - |
| Comparative Example 3 | <0.01 | 200 | 5.6 × 10⁴ | 10 | 3.1 | - |
| Comparative Example 4 | <0.01 | 210 | 5.7 × 10⁴ | 10 | 3.1 | - |

### Example 48

1 g of an acid organic material "resin A", 0.1 g of a silane coupling agent "KBM 503" and 9 g of TUFA were mixed and stirred to prepare a paste-like mixture for forming a layer. A pH of a 1 wt% aqueous solution of "resin A" was 2.9.

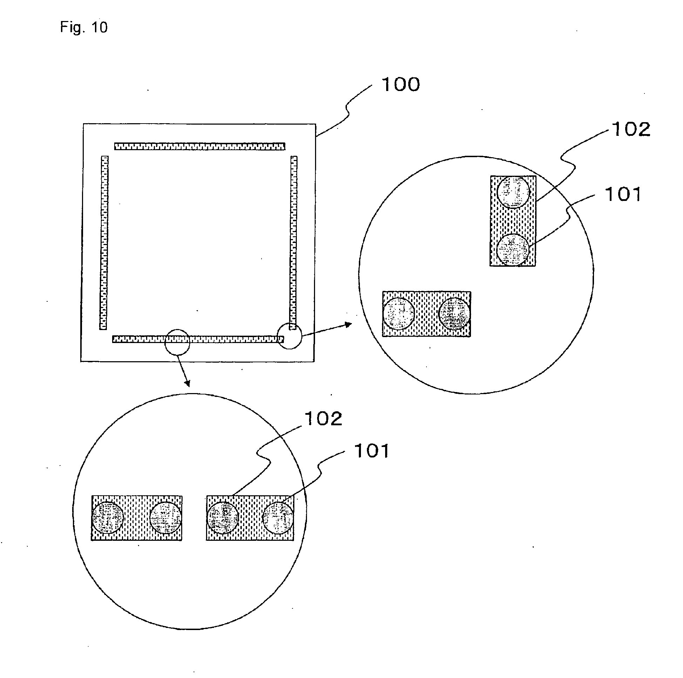

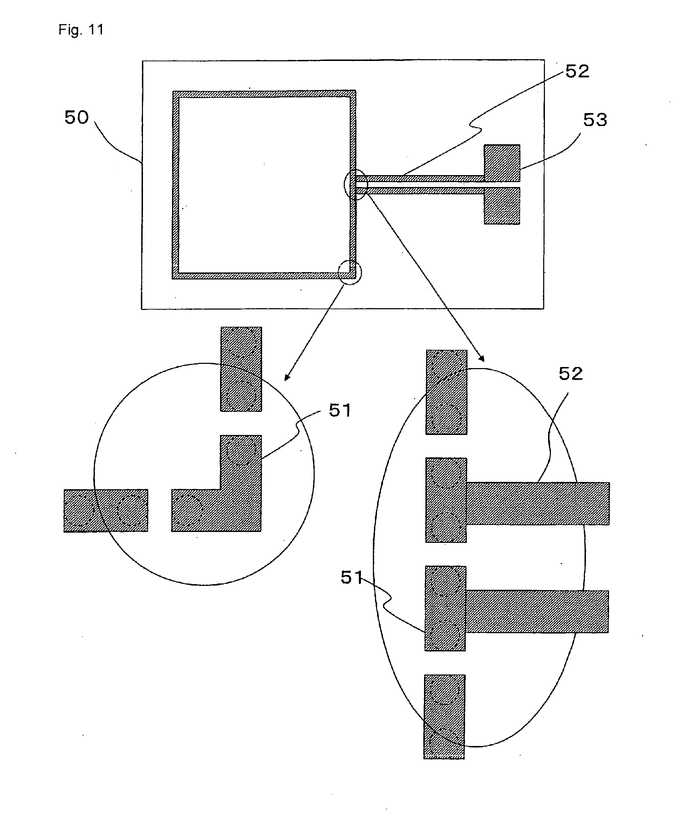

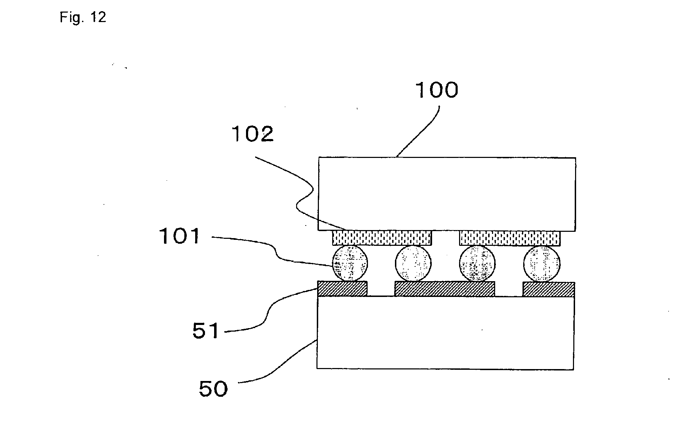

Next, a silicon substrate on which the semiconductor device for a test was flip-chip joined by a solder was prepared. This will be described by use of Figs. 10 to 12. First, in the semiconductor device for a test shown in Fig. 10, 240 (60 per a side) solder bumps 101 (Sn: 63%, Pb: 37%) of 150 µm in diameter are formed with 300-micron pitches at the periphery of a silicon chip 100 having a size of 20 mm × 20 mm. This was mounted on a silicon substrate 50 (30 mm × 50 mm) with a copper pad 51, shown in Fig. 11, using a flip-chip bonding apparatus "FC-2000" (manufactured by Toray Engineering Co., Ltd.) . The copper pad on the substrate is located relative to a solder bump of the semiconductor device for a test in such a way that a copper pad abuts against two solder bumps. In addition, in Fig. 11, positions of the solder bump of the semiconductor device corresponding to the copper pad on the substrate are indicated by dashed circular lines. Further, in the solder bump of the semiconductor device, two neighboring bumps are paired, and each thereof is formed on one aluminum pad 102 and there is continuity between two bumps. When the semiconductor device for a test is joined to the substrate, as shown in Fig. 12, there is continuity through the solder bump between the aluminum pad arranged on the semiconductor device for a test and the copper pad arranged on the substrate to configurate an electric line which connects the semiconductor device for a test to the substrate in the form of daisy chain. Copper wirings 52 are drawn from the copper pads corresponding to both ends of the daisy chain on the substrate, and terminals 53 for joining to the outside are disposed. Electric resistance between these two joint terminals (resistance between the external joint terminals) is almost zero if all joint areas are joined well, but since resistance increases even though a defective joint area is only one, pass/fail of joint can be judged.

The substrate having the semiconductor device for a test thus mounted was heated at a peak temperature of 240°C for 30 seconds in a reflow oven and thereby the solder bump reflow was carried out to join the semiconductor device to the substrate. Then, the paste-like mixture for forming a layer was flown into the joint area with a dropper. In this time, the mixture for forming a layer was run over out of the joint area and spreads on an upper area of the semiconductor device for a test and the surface of the silicon substrate while being applied. Then, the substrate was heated at 90°C for 1 hour in the air, and after heating treatment, the substrate was immersed in acetone for 30 seconds, cleaned with ultrapure water, and dried at 90°C for 15 minutes. In the dried substrate, only a metal joint area between the semiconductor device for a test and the substrate, and a copper wiring from the joint area on the substrate were covered with a layer, and an upper area of the semiconductor device for a test and the surface of the silicon substrate other than that were not covered with a layer. Then, the substrate was cured at 200°C for 1 hour in a nitrogen atmosphere to cure a layer. A resistance value between external joint terminals of the resulting substrate having the semiconductor device for a test mounted was 0 Ω.

Next, a thermal cycle test of the substrate having the semiconductor device for a test mounted, in which maintaining at -40°C for 30 minutes and maintaining at 125°C for 30 minutes form a 1 cycle and this cycle is repeated 1000 times, was carried out. A resistance value between external joint terminals after the test indicated 0 Ω, and therefore it was confirmed that there was not a defective location in a daisy chain and the substrate was well joined.

### Comparative Example 6

1g of bisphenol A epoxy resin "jER 828" , 0.05 g of a silane coupling agent "KBM 503", 0.05 g of a thermal polymerization initiator "Curezol 2PZ" and 9 g of THFA were mixed and stirred to prepare a paste-like mixture for forming a layer. A pH of a 1 wt% aqueous solution of "jER-828" was 4.5.

Next, as with Example 48, the paste-like mixture was flown, by a dropper, into a joint area of the silicon substrate on which the semiconductor device for a test was flip-chip joined by a solder. In this time, the mixture was run over out of the joint area and spreads on an upper area of the semiconductor device for a test and the surface of the silicon substrate while being applied. Then, the substrate was heated at 90°C for 1 hour in the air, and after heating treatment, the substrate was immersed in acetone for 30 seconds, cleaned with ultrapure water, and dried at 90°C for 15 minutes. In the obtained substrate, the layer was run over out of the joint area and covered the upper area of the semiconductor device and a wide area of the silicon substrate. Then, the substrate was cured at 200°C for 1 hour in a nitrogen atmosphere to cure a resin layer. A resistance value between external joint terminals of the resulting test sample was 0 Ω.

Next, a thermal cycle test of 1000 cycles for the substrate having the semiconductor device for a test mounted was carried out as in Example 48. A resistance value between external joint terminals after the test was 10 MΩ or more. Further, a layer around the joint area of the semiconductor device was observed with an optical microscope, and it was found that many fine cracks existed.

### Explanation of Symbols

- 50: a silicon substrate
- 51: a copper pad
- 52: a copper wiring
- 53: a terminal
- 100: a silicon chip
- 101: a solder bump
- 102: an aluminum pad

## Claims

1. A process for production of core-shell particles comprising the step of mixing an acid organic material or phosphoric acid with metal particles to form, on the surface of the metal particle, a layer containing an organic acid salt formed from both the acid organic material and the metal or phosphate formed from both the phosphoric acid and the metal.

2. The process for production of core-shell particles according to claim 1, wherein a material of the metal particle is a pure metal of any of copper, silver, aluminum, iron, zinc, tin and gold, or an alloy containing at least one of these elements.

3. The process for production of core-shell particles according to claim 1 or 2, wherein the acid organic material is a carboxyl group-containing resin or a phosphate-containing resin.

4. The process for production of core-shell particles according to any of claims 1 to 3, using the metal particle, the surface of which is treated with a silane coupling agent.

5. The process for production of core-shell particles according to any of claims 1 to 4, wherein a mixed amount of
the metal particles is 5 vol% or more and 40 vol% or less of a total amount of the mixture.

6. A core-shell particle obtained by the process according to any of claims 1 to 5, wherein a layer containing an organic acid salt or phosphate is formed on the surface of the metal particle.

7. A paste composition containing core-shell particles produced by using the process for production of core-shell particles according to any of claims 1 to 5, and a matrix resin.

8. A sheet composition containing core-shell particles produced by using the process for production of core-shell particles according to any of claims 1 to 5, and a matrix resin.

9. A process comprising the step of bringing an acid organic material or phosphoric acid into contact with a metal to form, on the surface of the metal, a layer containing an organic acid salt formed from both the acid organic material and the metal or phosphate formed from both the phosphoric acid and the metal.

10. A process for production of a covered metal-wiring circuit board comprising the step of applying a solution containing an acid organic material or phosphoric acid onto a circuit board having a metal-wiring to form, on the surface of a metal on the circuit board, a layer containing an organic acid salt formed from both said acid organic material and said metal or phosphate formed from both said phosphoric acid and said metal.
